# EUROPEAN PATENT SPECIFICATION

(11) **EP 4 451 419 B1**
(45) Date of publication and mention of the grant of the patent: **11.03.2026**
(21) Application number: 24170780.1
(22) Date of filing: 17.04.2024
(51) Int. Cl.: H01M 10/42, H01M 10/48

(54) **BATTERY IDENTIFICATION DEVICE, BATTERY IDENTIFICATION METHOD, AND STORAGE MEDIUM**
BATTERIEIDENTIFIKATIONSVORRICHTUNG, BATTERIEIDENTIFIKATIONSVERFAHREN UND SPEICHERMEDIUM
DISPOSITIF D'IDENTIFICATION DE BATTERIE, PROCÉDÉ D'IDENTIFICATION DE BATTERIE ET SUPPORT D'INFORMATIONS

(30) Priority: 18.04.2023 JP 2023068124
(43) Date of publication of application: 23.10.2024
(73) Proprietor: Yokogawa Electric Corporation, Tokyo 180-8750 (JP); HONDA MOTOR CO., LTD., Tokyo 105-8404 (JP)
(72) Inventor: OKANO, Jun, Saitama, 351-0193 (JP); ONOUE, Yukiko, Tokyo, 107-8556 (JP); OMICHI, Kaoru, Saitama, 351-0193 (JP); TOMINAGA, Yuki, Saitama, 351-0193 (JP); TAKENAKA, Kazuma, Tokyo, 180-8750 (JP); TERAO, Minako, Tokyo, 180-8750 (JP); NOGUCHI, Naoki, Tokyo, 180-8750 (JP); TSUKANO, Masahito, Tokyo, 180-8750 (JP); YOSHITAKE, Satoshi, Tokyo, 180-8750 (JP)
(74) Representative: Kiwit, Benedikt

(56) References cited:
- JP-A- H06 215 802
- JP-B2- 5 167 521
- US-B2- 7 847 515

## Description

### BACKGROUND

### Field of the Invention

The present invention relates to a battery identification device, a battery identification method, and a storage medium.

### Description of Related Art

In the related art, a method of identifying a type of battery based on a direct-current internal resistance at the time of charging of the battery and a direct-current internal resistance at the time of discharging is known (PCT International Publication No. WO 2015 / 133 068 A1). In this method, a resistor with a predetermined resistance value is attached to a battery in advance, and the type of battery is determined by measuring the resistance value at the time of identification. A method of attaching an IC chip to a battery and determining the type of battery based on an identification signal output from the IC chip is also known.

### SUMMARY

However, in the related art, a component such as a resistor or an IC chip has to be attached to a battery, which increases costs. When such a component is imitated, the component may be attached to an unintended battery, and thus a type of the battery cannot be correctly identified. The type of battery mentioned herein includes a type indicating whether the battery is a valid battery and a type indicating whether the battery is an intended battery. **In** the related art, there is a likelihood that the validity or individuality of a battery will not be able to be correctly identified.

JP H06 215 802 A discloses a measuring device which determines the chemical composition of a battery or accumulator by measuring the induction response thereof to an alternating magnetic field. The measuring device comprises an exciting coil coupled to a biasing means to generate said alternating magnetic field, a positioning means for positioning the battery or accumulator in the alternating magnetic field, and a measuring means for measuring the induction response of the battery or accumulator, wherein a ferromagnetic portion of the battery or accumulator is saturated by the applied magnetic field.

The present invention was made in consideration of the aforementioned circumstances, and an objective thereof is to provide a battery identification device, a battery identification method, and a storage medium that can identify the type of battery without attaching an identification component thereto.

A battery identification device, a battery identification method, and a storage medium according to the present invention employ the following configurations.
(1) According to an aspect of the present invention, there is provided a battery identification device for identifying a battery including a plurality of battery cells, the battery identification device including a first probe for applying current to the battery, a second probe for measuring a magnetic field generated around the battery, a storage device configured to store a program and a hardware processor, wherein the hardware processor executes the program stored in the storage device to perform: applying, by the first probe, an identification current to the battery, which is a specific current for identifying the battery, measuring, by the second probe, a distribution of the magnetic field which is generated by applying the identification current flowing to the battery; and reading information on identity between both results which is determined by comparing a measurement result of the distribution of the magnetic field with a prescribed value of magnetic field information correlated with the type of battery.
(2) In the aspect of (1), each battery cell of the plurality of battery cells has substantially rotational symmetry with respect to one axis and includes a positive electrode having substantially rotational symmetry with respect to the axis and the negative-electrode having lower rotational symmetry to the axis than that of the outer shape or does not have rotational symmetry to the axis.

Specifically, in a possible application, an internal structure of each battery cell has rotational symmetry with respect to the axis which is lower than the rotational symmetry outside of the internal structure or does not have rotational symmetry with respect to the axis.

Furthermore in (2), the plurality of battery cells are arranged in a fixed position and orientation in the battery such that the axes are parallel to each other, and the battery identification device is configured to scan the magnetic field along a surface of the battery parallel or perpendicular to the axis.

(3) In the aspect of (1), the battery has a configuration in which a battery module including a plurality of battery cells is accommodated in a battery pack storing individual identification information, and the hardware processor stores the individual identification information as a type of the battery and stores the prescribed value of the magnetic field information in correlation with the individual identification information.
(4) In the aspect of (3), the hardware processor additionally acquires the individual identification information from the battery pack and identifies individual batteries by acquiring the prescribed value correlated with the individual identification information and comparing the acquired prescribed value with the magnetic field information.
(5) In the aspect of (1), the hardware processor additionally performs a control process of outputting electric power to the battery or the battery cell or receiving an input of electric power from the battery or the battery cell.
(6) In the aspect of (1), the battery has a configuration in which a plurality of battery modules each including a plurality of battery cells are accommodated in a battery pack, and the hardware processor performs measuring magnetic field characteristics in a range in which the magnetic field characteristics of the plurality of battery modules are observed.
(7) In the aspect of (1), the hardware processor measures the magnetic field using a magnetic element array board in which a plurality of magnetic elements are arranged.
(8) According to another aspect of the present invention, there is provided a battery identification method of identifying a battery including a plurality of battery cells that is performed by a battery identification device, the battery identification method including: applying, by a first probe, an identification current to the battery, which is a specific current for identifying the battery, measuring, by a second probe, a distribution of the magnetic field which is generated by applying the identification current flowing to the battery; and reading information on identity between both results which is determined by comparing a measurement result of the distribution of the magnetic field with a prescribed value of magnetic field information correlated with the type of battery.
(9) According to another aspect of the present invention, there is provided a non-transitory storage medium storing a program, the program causing an identification device for identifying a battery including a plurality of battery cells to perform: applying, by a first probe, an identification current to the battery, which is a specific current for identifying the battery, measuring, by a second probe, a distribution of the magnetic field which is generated by applying the identification current flowing to the battery; and reading information on identity between both results which is determined by comparing a measurement result of the distribution of the magnetic field with a prescribed value of magnetic field information correlated with the type of battery.

According to the aspects of (1) to (9), it is possible to nondestructively and noninvasively identify the type of battery without attaching an identification component thereto.

### BRIEF DESCRIPTION OF THE DRAWINGS

FIG. 1 is a diagram schematically illustrating the configuration of the battery cell.
FIG. 2 is a diagram schematically illustrating the configuration of the battery unit.
FIG. 3 is a diagram schematically illustrating an example of a configuration of a battery identification device.
FIG. 4 is a diagram illustrating an example of details of correlation information.
FIG. 5 is a diagram schematically illustrating a configuration for measurement which is performed to identify a battery type of a target battery unit by the battery identification device.
FIG. 6 is a diagram schematically illustrating a magnetic field distribution which is measured through scanning of a first side surface.
FIG. 7 is a diagram illustrating an example of a CT image of a battery unit of which a second side surface is imaged.
FIG. 8 is a diagram illustrating a battery identification method of identifying a battery type of a battery unit based on magnetic field characteristics which are measured through scanning of a first side surface.
FIG. 9 is a diagram illustrating an example of a configuration of a battery unit according to a modified example.
FIG. 10 is a diagram illustrating an example of a configuration of a battery sharing system including a battery identification device and a BEX according to a modified example.
FIG. 11 is a sequence diagram illustrating an example of a process flow of verifying validity of a returned MPP which is performed by the battery sharing system.

### DETAILED DESCRIPTION OF THE INVENTION

Hereinafter, a battery identification device, a battery identification method, and a storage medium according to an embodiment of the present invention will be described with reference to the accompanying drawings.

In the following embodiment, a method of identifying the type of battery unit including a plurality of battery cells will be described. In this embodiment, an individual battery cell constituting the battery unit is based on the premise of a cylindrical battery cell including a wound product in which electrodes are wound and using circular top and bottom surfaces as a positive-electrode terminal or a negative-electrode terminal. The battery unit according to this embodiment is an example of a "battery" in the claims.

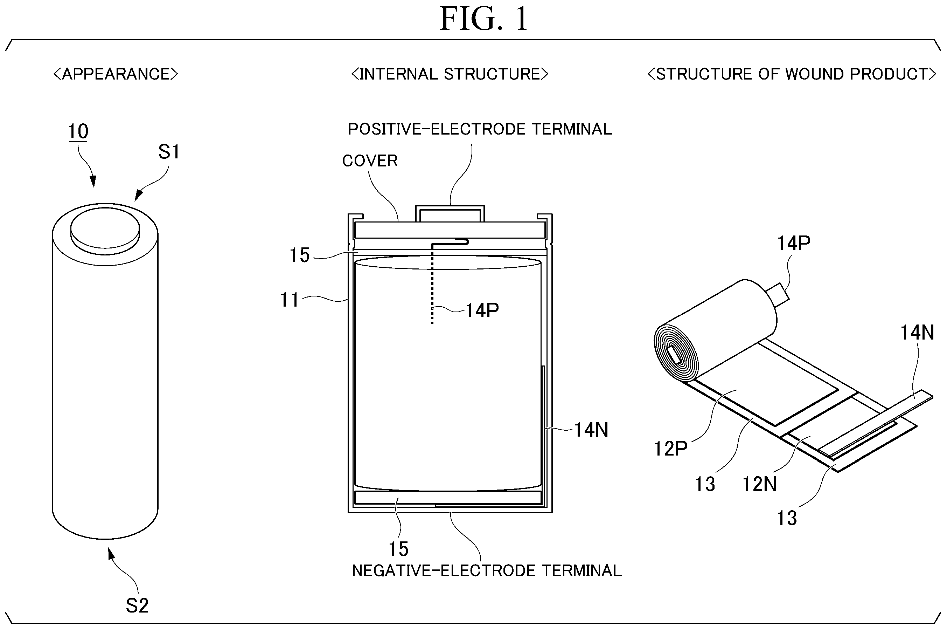

FIG. 1 is a diagram schematically illustrating the configuration of the battery cell. In FIG. 1, the left part illustrates the appearance of a battery cell 10 according to the embodiment, and the central part is a sectional view schematically illustrating an internal structure of the battery cell 10. The right part is a diagram illustrating a structure of a wound product in the battery cell 10. As illustrated in FIG. 1, the battery cell 10 has a cylindrical shape, one end surface thereof is formed as a positive-electrode terminal S1, and the other end surface is formed as a negative-electrode terminal S2. The battery cell 10 has a configuration in which a wound product 15 in which a stacked body in which a positive electrode 12P and a negative electrode 12N are separated by a separator 13 is wound, a positive-electrode tab 14P provided on the positive electrode 12P, a negative-electrode tab 14N provided on the negative electrode 12N, and an insulator 16 for insulating the wound product 15, the positive-electrode terminal, and the negative electrode terminal from each other are accommodated in an outer can 11. The positive electrode 12P and the negative electrode 12N are immersed in an electrolyte (not illustrated) in a state in which they are separated from each other by the separator 13 and are wound. The positive-electrode tab 14P electrically connects the positive electrode 12P and the positive-electrode terminal S1, and the negative-electrode tab 14N electrically connects the negative electrode 12N and the negative-electrode terminal S2. The positive-electrode tab 14P is disposed at a winding start of the positive electrode 12P, and the negative-electrode tab 14N is disposed at a winding end of the negative electrode 12N. The wound product 15 is wound such that the negative electrode 12N faces outward.

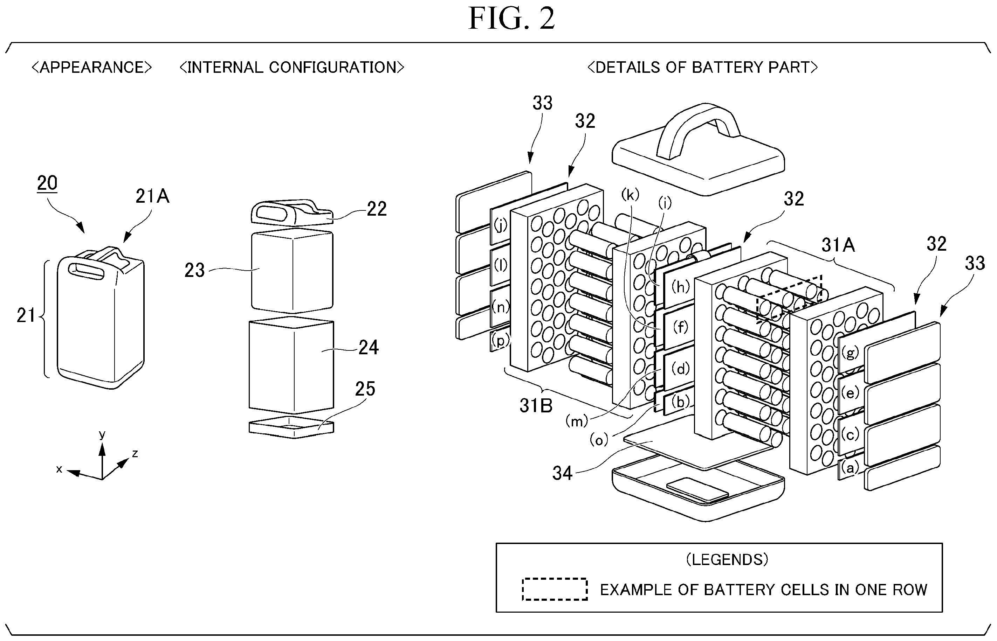

FIG. 2 is a diagram schematically illustrating the configuration of the battery unit. In FIG. 2, the left part illustrates an appearance of a battery unit 20 according to this embodiment, and the central part illustrates an internal configuration of the battery unit 20. As illustrated in FIG. 2, the battery unit 20 has a configuration in which a top case 22, a battery part 23, a side case 24, and a bottom case 25 are accommodated in a housing 21 with a grip 21A. A plurality of battery cells 10 are welded to a busbar which will be described later or are electrically connected through fastening with screws, are fixed such that they do not rotate, and are accommodated in cell holders 31A and 31B. In the battery unit 20, the battery cells 10 are arranged such that battery cells of two neighboring columns alternate in polarity column by column.

In the battery unit 20, a busbar 32 connecting the battery cells 10 in series is provided. The busbar 32 in the example illustrated in FIG. 2 includes sub-bars (a) to (p) to connect the battery cells 10 corresponding to a row (three battery cells) in series to the battery cells 10 in nearby columns. For example, one end sub-bar (a) of the busbar 32 is electrically connected to the positive-electrode terminal, and the other end sub-bar (p) is electrically connected to the negative-electrode terminal. With this configuration, the battery cells 10 in the rows are connected in series by the busbar 32 in the order of sub-bars (a) to (p). The sub-bars (h) and (i) of the busbar 32 are directly connected to each other, whereby a group of the battery cells 10 in the cell holder 31B is connected in series to a group of the battery cells 10 in the cell holder 31A. In the housing 21, a battery management unit (BMU) 34 having a function of managing the battery part 23 in addition to a heat-dissipation heat transfer sheet 33 installed on side surfaces is provided. In the battery unit 20, the plurality of battery cells 10 are arranged sideways on the bottom surface of the battery unit 20. In other words, the plurality of battery cells 10 are arranged such that a cylindrical axis thereof is parallel to the bottom surface of the battery unit 20.

The BMU 34 has, for example, a function of controlling charging or discharging of the battery part 23, a function of controlling a direction in which a current flows or a voltage value, a function of monitoring states of the battery cells 10, and an on/off control function of switching a battery circuit between an on state and an off state. The BMU 34 includes a storage unit for storing information required for various management functions or a communication unit for communicating with an external device.

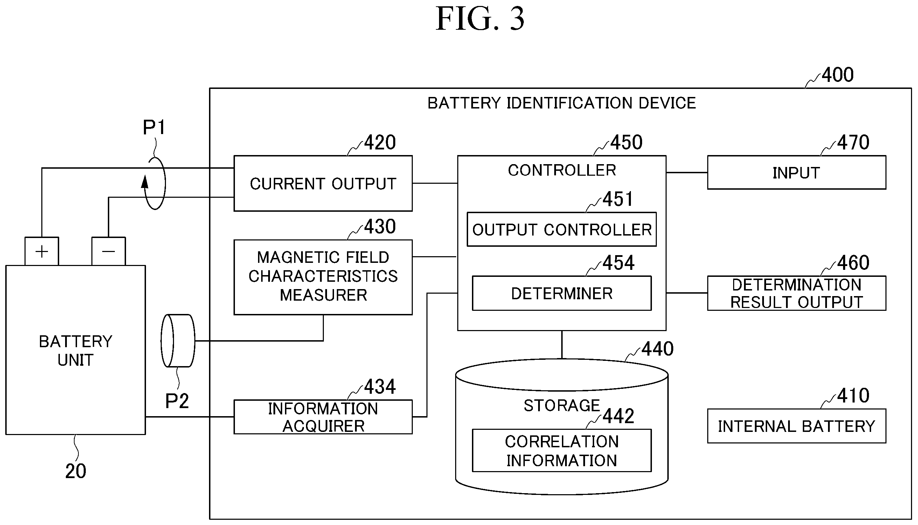

FIG. 3 is a diagram schematically illustrating an example of a configuration of a battery identification device 400 according to this embodiment. The battery identification device 400 is a device that identifies a type of the battery unit 20. The battery identification device 400 includes an internal battery 410, a current output 420, a magnetic field characteristics measurer 430, an information acquirer 434, a storage 440, a controller 450, a determination result output 460, and an input 470. These constituents are realized, for example, by causing a hardware processor such as a central processing unit (CPU) to execute a program (software). Some or all of the constituents may be realized by hardware (a circuit unit including circuitry) such as a large scale integration (LSI) circuit, an application-specific integrated circuit (ASIC), a field-programmable gate array (FPGA), or a graphics processing unit (GPU) or may be cooperatively realized by software and hardware. Here, the program may be stored in a storage device (a storage device including a non-transitory storage medium) such as a hard disk drive (HDD) or a flash memory in advance or may be stored in a detachable storage medium (a non-transitory storage medium) such as a DVD or a CD-ROM and installed by setting the storage medium into a drive device.

The internal battery 410 is a battery that supplies electric power required for operations of the battery identification device 400. The functional units of the battery identification device 400 can operate with electric power supplied from the internal battery 410. The internal battery 410 may be a battery or may be an interface that acquires electric power from another power supply.

The current output 420 is a current application circuit that is controlled to apply a specific current to the battery unit 20. A specific current is a current (hereinafter referred to as an "identification current") applied to the battery unit 20 for the purpose of identifying a battery type of the battery unit 20. The current output 420 applies a current with an intensity instructed by the controller 450 to the battery unit 20. The current output from the current output 420 is applied to the battery unit 20 via a probe P1.

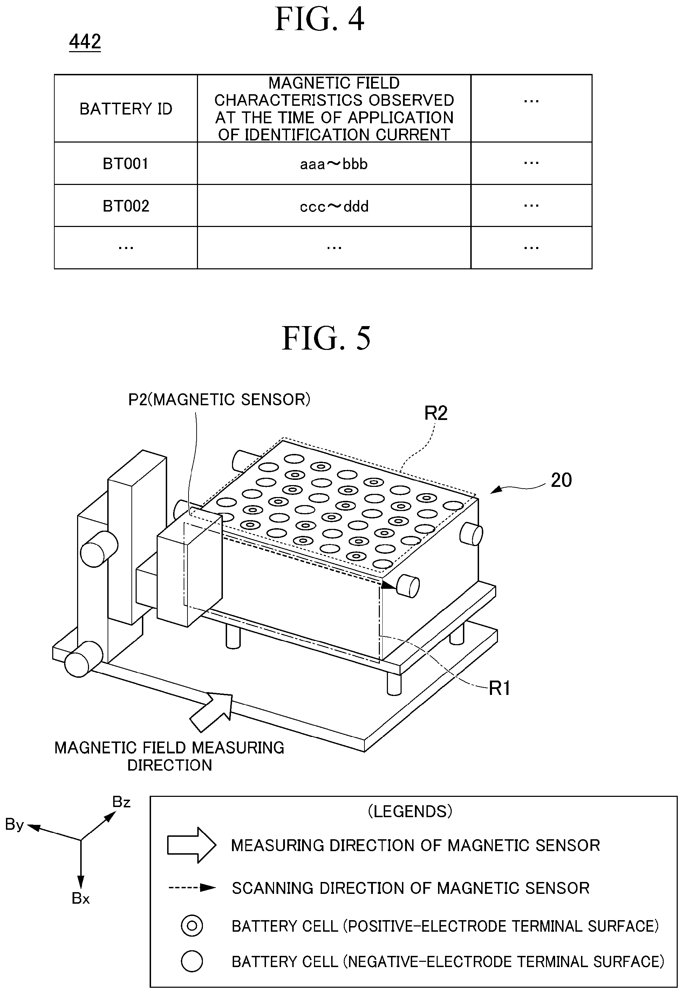

The magnetic field characteristics measurer 430 is a circuit that measures magnetic field characteristics of a measurement target based on a signal detected by a magnetic field detector P2. The magnetic field detector P2 is, for example, a magnetic probe including a magnetic element therein or a magnetic element array board in which a plurality of magnetic elements are arranged. The magnetic elements in the magnetic element array board may be arranged at regular intervals or may be arranged at irregular intervals. Each magnetic element may be a single-axis measuring element or may be a three-axis measuring element. It is preferable that a single-axis measuring element be disposed such that a magneto-sensitive surface thereof faces a circumferential direction of the battery cell (a y-axis direction in FIG. 5). This is for easily acquiring a magnetic field distribution in which direction arrangement of a battery cell 10 and a presence position of a collector tab are reflected by causing a macro current of the battery cell 10 and a current flowing in the collector tab to orthogonally cross the magneto-sensitive surface. Each magnetic element may be an analog element or may be a digital element. Each magnetic element may be, for example, a Hall element, a magnetoresistance element such as an anisotropic magnetoresistance effect (AMR) element, a giant magnetoresistance effect (GMR) element, or a tunnel magnetoresistance effect (TMR) element, a magneto-impedance (MI) element, a flux gate, or a thin-film magnetic element based on an anomalous Hall effect using a topological magnetic substance. When an alternating current flows in a measurement target, a pickup coil may be used as a magnetic element. A range in which a magnetic field is detected by the magnetic field detector P2 may be the whole measuring surface of the battery unit 20 or an arbitrary part thereof as long as information sufficient to identify a battery type can be acquired. The magnetic element array board may have a size covering the whole measuring range of the measuring surface of the battery unit 20 or may scan the measuring surface with a size covering a part of the measuring range. A measuring position or a measuring timing of magnetic field characteristics or the like is assumed to be appropriately controlled by the controller 450. The magnetic field characteristics measurer 430 outputs a measured value of the magnetic field characteristics acquired for the battery unit 20 to the controller 450.

The information acquirer 434 is connected to an information communication terminal of the battery unit 20. For example, the information acquirer 434 can acquire information stored in a storage of the battery unit 20 or transmit information to the storage of the battery unit 20 through communication with the battery unit 20. For example, individual identification information of the battery unit 20 or the like is stored in the storage of the battery unit 20. The individual identification information is, for example, a manufacturing ID. The individual identification information may be an example of a "battery type."

The storage 440 is configured, for example, using a magnetic storage device such as a hard disk drive (HDD) or a semiconductor storage device such as a solid state drive (SSD) or configured as a database (DB) in a cloud. The storage 440 provides a storage area for storing various types of information of the operations of the battery identification device 400. Correlation information 442 on the battery unit 20 is stored in advance in the storage 440. The correlation information 442 is information in which at least magnetic characteristics which are observed when an identification current is applied to the battery unit 20 are correlated with a type (a battery type) of the battery unit 20 (see FIG. 4). For example, the correlation information 442 can be generated based on a result of a test for measuring magnetic field characteristics using an identification current for each battery type to be identified. In addition to the correlation information 442, for example, a measurement result of magnetic field characteristics of the battery unit 20, a determination result of a battery type, setting information of a current applied to the battery unit 20, various programs for realizing the controller 450, and the like may be stored in the storage 440.

The controller 450 controls the constituents of the battery identification device 400 to identify a battery type of a target battery unit 20. In the following description, a battery unit 20 of which a battery type is to be identified is referred to as a target battery unit 20. The controller 450 includes, for example, an output controller 451 and a determiner 454. The output controller 451 has a function of applying an identification current to a target battery unit 20 by controlling an output intensity of the current output 420. For example, the output controller 451 may apply an alternating current varying in a sinusoidal shape to the target battery unit 20 by continuously changing the output intensity of the current output 420. The output controller 451 may apply a direct-current varying in a rectangular wave shape to the target battery unit 20 by changing the output intensity of the current output 420 at predetermined timings.

The output controller 451 may be configured to detect connection of the target battery unit 20 to the battery identification device 400 and to start application of an identification current to the target battery unit 20. The battery identification device 400 includes an input device such as a mouse or a keyboard, the output controller 451 may be configured to start application of an identification current to the target battery unit 20 in response to a user's input operation.

The determiner 454 determines a battery type of the target battery unit 20 based on a value of the magnetic field characteristics measured from the target battery unit 20. More specifically, the determiner 454 determines the battery type corresponding to the value of the magnetic field characteristics measured from the target battery unit 20 based on the correlation information 442. For example, in the example illustrated in FIG. 4, when the measured value of the magnetic field characteristics is in a range of "aaa to bbb," the determiner 454 can determine that the battery type of the target battery unit 20 is "BT001." The determiner 454 outputs the determination result of the battery type to the determination result output 460. The determiner 454 is configured in cloud. The storage 440 and the determiner 454 are an example of a "reader." When at least one of the storage 440 and the determiner 454 is in cloud, the battery identification device 400 may have a function of communicating with the cloud and acquiring (reading) at least one of a prescribed value and information on identity from the cloud (may include a reader).

The correlation information 442 may be configured to store a feature quantity acquired based on magnetic field characteristics in correlation with the battery type instead of/in addition to the magnetic field characteristics. In this case, the determiner 454 may be configured to determine the battery type of the target battery unit 20 based on the feature quantity acquired based on the measured value instead of/in addition to the measured value of the magnetic field characteristics acquired from the target battery unit 20. The feature quantity may have a value acquired for each individual measured value or may be a statistical value acquired for a plurality of measured values.

The determination result output 460 outputs the determination result of the battery type output from the determiner 454 in a predetermined form. For example, the determination result output 460 may display the determination result on a display device such as a liquid crystal display or an organic electroluminescence (EL) display. For example, the determination result output 460 may transmit the determination result to another communication device via a wired or wireless communication interface. The determination result output 460 may output voice indicating details of the determination result from a voice output device such as a speaker.

The input 470 has a function of inputting information to the battery identification device 400. For example, the input 470 may be configured to receive an information input operation via an input device such as a mouse or a keyboard. The input 470 may be configured to input (receive) information by communication via a wired or wireless communication interface. The input 470 outputs the input information to the controller 450.

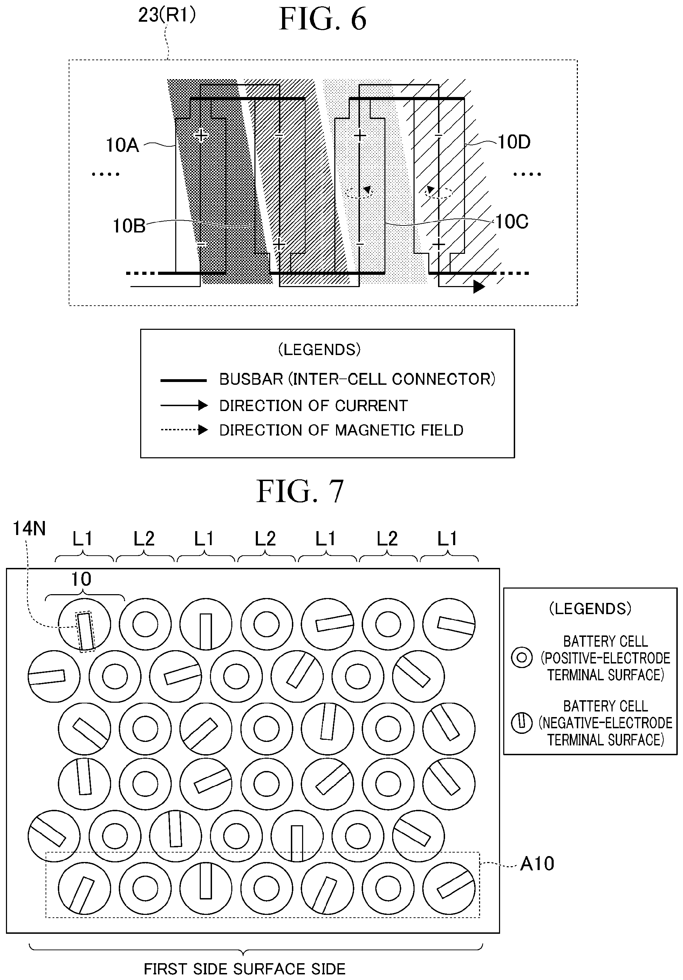

FIG. 5 is a diagram schematically illustrating a configuration for measurement which is performed to identify a battery type of a target battery unit 20 by the battery identification device 400. More specifically, the battery identification device 400 measures magnetic field characteristics in the vicinity of a first side surface R1 of the target battery unit 20 in a state in which an identification current is applied. The battery identification device 400 recognizes a distribution of directions (angles) of the battery cells 10 in the target battery unit 20 based on the measurement result. Control of the magnetic field characteristics measurer 430 associated with measurement of magnetic field characteristics is performed by the controller 450. In the following description, a view of an internal structure of the target battery unit 20 when seen from a second side surface R2 side (FIG. 7) will be described for describing the directions of the battery cells 10. Measurement in the vicinity of the first side surface R1 is an example, and measurement may be performed in the vicinity of the second side surface R2.

The first side surface R1 is a side surface facing side surfaces of internal battery cells 10 out of the side surfaces of a battery unit 20. In other words, the first side surface R1 is a side surface parallel to a cylindrical center axis of each internal battery cell 10 out of the side surfaces of the battery unit 20. On the other hand, the second side surface R2 is a side surface facing a circular end surface of each internal battery cell 10 out of the side surfaces of the battery unit 20. In other words, the second side surface R2 is a side surface perpendicular to the cylindrical center axis of each internal battery cell 10 out of the sides surfaces of the battery unit 20. There are four side surface candidates for the first side surface R1 out of the side surfaces of the battery unit 20, and which side surface is set as the first side surface R1 may be arbitrarily selected according to a configuration of a measuring instrument, conditions of a measuring environment, or the like. Similarly, there are two side surface candidates for the second side surface R2 out of the side surfaces of the battery unit 20, and which side surface is set as the second side surface R2 may be arbitrarily selected according to a configuration of a measuring instrument, conditions of a measuring environment, or the like.

Here, a direction perpendicular to the first side surface R1 is defined as a z-axis direction, a direction perpendicular to the second side surface R2 is defined as an x-axis direction, and a direction perpendicular to the bottom surface of the battery unit 20 is defined as a y-axis direction. In a measured magnetic field B, an x-axis component is referred to as Bx, a y-axis component is referred to as By, and a z-axis component is referred to as Bz. As illustrated in FIG. 5, directions of terminals of a plurality of battery cells 10 in the battery unit 20 may not be uniform. For example, FIG. 5 illustrates an example in which a plurality of groups of battery cells 10 with the same direction of terminals are formed and the plurality of groups are arranged such that the directions of terminals alternate.

FIG. 6 is a diagram schematically illustrating a magnetic field distribution (a By component) which is measured through scanning of the first side surface R1. As described above with reference to FIG. 5, a plurality of battery cells 10 are arranged in different directions of terminals in the battery unit 20. FIG. 6 schematically illustrates a magnetic field distribution measured in the vicinity of the plurality of battery cells 10 arranged such that the directions terminals alternate. For example, FIG. 6 illustrates a magnetic field distribution of magnetic fields measured from a shallow side of the drawing surface on the first side surface R1 of the battery part 23 of the battery unit 20. As can be seen from FIG. 6, when an identification current is applied to a battery cell 10, a current density distribution in the battery cell 10 is higher in a part of a collector tab (a negative-electrode tab). Accordingly, a stronger magnetic field is observed in the battery cell 10 of which the collector tab is closer to the first side surface R1 out of the battery cells 10 with the same current direction. For example, in the example illustrated in FIG. 6, a stronger magnetic field than in a battery cell 10C is observed in a battery cell 10A, and a stronger magnetic field than in a battery cell 10D is observed in a battery cell 10B. Accordingly, in this case, it is predicted that a collector tab is present on the first side surface R1 side (a shallow side in the drawing) in the battery cell 10A and the battery cell 10B. This difference in a magnetic field intensity may be used as a feature quantity for identifying a battery type.

FIG. 6 illustrates an example in which battery cells 10 with different directions of terminals are connected in series and illustrates a state in which a plurality of battery cells 10 are connected by a busbar. In this configuration, it can be seen that the directions of the measured magnetic field distributions alternate along an array of the battery cells 10 (that is, signs are inverted) as illustrated in FIG. 6. That is, since a direction of a current flowing in the battery unit 20 changes when the direction of the battery cells 10 changes, a direction of a current for generating a magnetic field can be said to be change according to the directions of the battery cells 10. A size (thickness or length) of a battery cell 10 is reflected in a width of the alternating magnetic field distributions. In this way, since arrangement of the battery cells 10 and arrangement, length, or the like of busbars accompanying the arrangement affect a distribution of a measured magnetic field, the magnetic field distribution on the first side surface R1 can be used as a feature quantity for identifying a battery type of the battery unit 20. Directions of terminals of a plurality of battery cells 10 may be different from the example illustrated in FIG. 5 or 6 as long as features of a magnetic field (features based on directions of collector tabs of cylindrical battery cells 10 in the battery unit 20)) for identifying the same type of (with the same design or structure) battery unit 20.

FIG. 7 is a diagram illustrating an example of an internal structure of a battery unit 20 when seen from the second side surface R2 side. That is, FIG. 7 illustrates a sectional surface of the battery unit 20 taken along a plane parallel to a yz plane. FIG. 7 illustrates an image obtained by imaging the battery unit 20 in which battery cells 10 with different directions of terminals are arranged in a layered shape. In FIG. 7, a first layer L1 in which negative-electrode terminal surfaces face the shallow side of the drawing surface and a second layer L2 in which positive-electrode terminal surfaces face the shallow side of the drawing surface are alternately arranged. In FIG. 7, each circular image is a circular end surface of each of a plurality of battery cells 10. A rectangular object in some circular end surfaces is a negative-electrode tab 14N connected to the negative electrode 12N.

A battery cell 10 according to this embodiment has a cylindrical outer shape (rotational symmetry) and thus a direction thereof cannot be ascertained from the outer shape. On the other hand, as illustrated in FIG. 7, the internal structure of the battery cell 10 has no rotational symmetry due to presence of a negative-electrode tab. That is, with attention to the internal structure, each battery cell 10 has a direction. In the process of manufacturing the battery unit 20, directions at the time of arranging a plurality of battery cells 10 are not controlled. Accordingly, the directions of the plurality of battery cells 10 in the battery unit 20 are random, thus the direction of the negative-electrode tab 14N is also random, and the direction cannot be visually ascertained due to rotational symmetry of the outer shape. In this way, the battery unit 20 is manufactured such that the angles of the negative-electrode tabs 14N of the plurality of battery cells 10 are allowed to be random. On the other hand, the positive-electrode terminals S1 of the battery cells 10 in the second layer L2 cannot be seen from FIG. 7 because the positive-electrode terminals S1 face the shallow side, but the angles of the negative-electrode tabs 14N of the battery cells 10 in the second layer L2 are similarly random. On the other hand, since the end surfaces of the battery cells 10 are fixed to the busbars, the angles of the negative-electrode tabs 14N of the battery cells 10 in the manufactured battery unit 20 are considered not to change.

In this way, randomness in angle of the negative-electrode tabs 14N can be used as a feature quantity for identifying individuality of the battery unit 20. In FIG. 7, the internal structure of the whole second side surface R2 is illustrated for the purpose of easy understanding, but the feature quantity of the whole second side surface R2 does not need to be acquired as long as randomness required for identifying the individuality can be secured. As described above, when an identification current is applied to a battery cell 10, a current density distribution in the battery cell 10 is higher in a part corresponding to the collector tab (the negative-electrode tab). Therefore, the battery identification device 400 may be configured to identify the battery unit 20 based on measurement results of magnetic field characteristics of the first side surface R1. With measurement of a magnetic field on the first side surface R1, an influence of battery cells 10 other than a first row (a range indicated by a dotted line A10) may be included in the measurement results, which is good for acquiring features specific to individuals. In this case, the angle of the collector tab does not need to be identified in identifying an individual. That is, a magnetic field distribution (characteristics) specific to an individual (which varies depending on the individuals) which is generated according to the direction of the collector tab specific to the individual can be observed by measuring the magnetic field characteristics of the first side surface R1. The angle of the negative-electrode tab is mentioned herein, but an angle of a positive-electrode tab may be used according to the structure of the battery cells 10.

For example, it is assumed that the battery identification device 400 stores a collector tab feature quantity acquired at the time of delivery of the battery unit 20 in the storage 440 in correlation with individual identification information in advance. In this case, by identifying a collector tab feature quantity identical to (or having high identity to) the collector tab feature quantity acquired at the time of inspection out of the collector tab feature quantities stored in the storage 440, the battery identification device 400 can identify the individuality of the target battery unit 20 the individual identification information correlated therewith. In addition to the timing of delivery of a product, the collector tab feature quantity may be acquired at each measuring timing, and a magnetic field of which identity between individuals has been ascertained may be stored for reference. By updating a width of an individual identification determination value, it is possible to improve reliability of identification at a next timing. Data stored as described above may be weighted along the time axis and used for determination. There is a likelihood that slight change in an internal state due to dust or vibration attached to an armor during operation or the like has been absorbed.

The collector tab feature quantity can also be used for ascertaining whether the battery unit 20 has been altered. For example, it is assumed that collector tab feature quantities acquired at the time of delivery of battery units 20 are stored in storages of the battery units 20. In this case, the battery identification device 400 determines whether a battery unit 20 has been altered by determining whether the collector tab feature quantity stored in the storage of the battery unit 20 is identical to the collector tab feature quantity acquired at the time of inspection. Since an angle of a collector tab does not change after manufacturing as described above, the battery identification device 400 determines that "it has not been altered" when both angles are identical and determine that "it has been altered" when both angles are not identical.

The battery identification device 400 may perform determination based on identity in individual identification information in addition to determination based on the collector tab feature quantity. For example, it is assumed that individual identification information of a battery unit 20 is stored in the storage of the battery unit 20 and a collector tab feature quantity of the battery unit 20 is stored in the storage 440 of the battery identification device 400 in correlation with the individual identification information. In this case, the battery identification device 400 reads the individual identification information from the battery unit 20 and acquires the collector tab feature quantity correlated with the individual identification information from the storage 440. The battery identification device 400 may determine that an internal component (such as a battery cell 10) of the battery unit 20 is a valid product (that alteration of the component or the like has not been performed) when the acquired collector tab feature quantity is identical to the collector tab feature quantity acquired at the time of inspection.

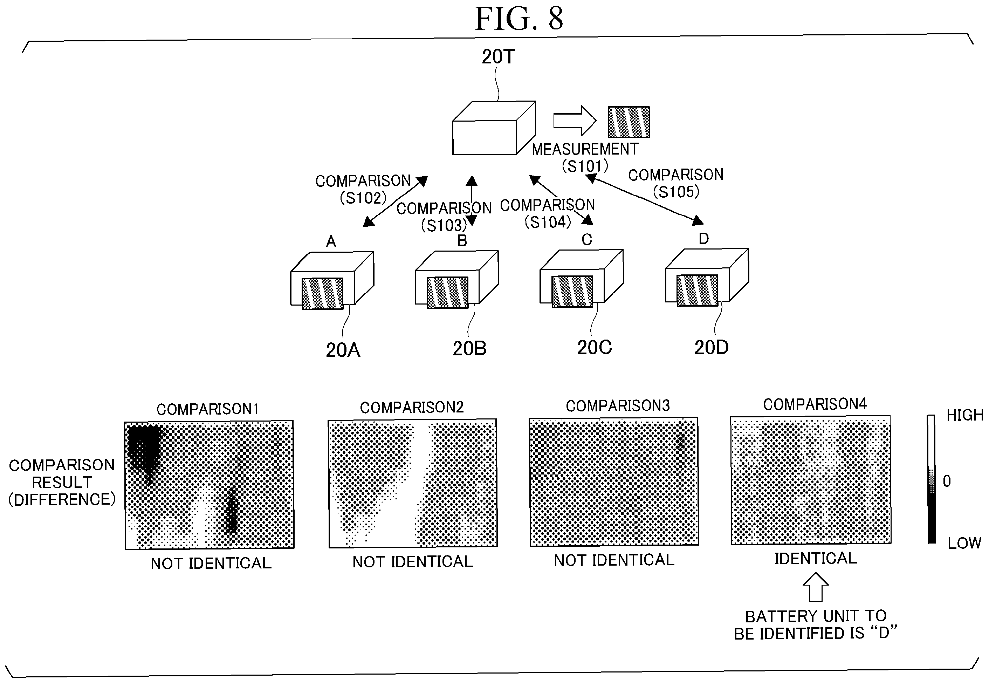

FIG. 8 is a diagram illustrating images of a battery identification method of identifying a battery type of a battery unit 20 based on magnetic field characteristics which are measured through scanning of the first side surface R1. **In** FIG. 8, an example in which a battery unit 20T is an identification target and a battery unit 20D corresponding thereto is identified out of battery units 20A, 20B, 20C, and 20D is illustrated. In this case, it is assumed that the battery identification device 400 stores correlation information 442 of magnetic field characteristics measured from the first side surface R1 in advance (for example, at the time of delivery of a product) for each of the battery units 20A, 20B, 20C, and 20D.

In this case, first, the battery identification device 400 measures the magnetic field characteristics of the first side surface R1 of the battery unit 20T (S101). Subsequently, the battery identification device 400 determines whether the magnetic field characteristics of the battery unit 20T measured in Step S101 are identical to the magnetic field characteristics of the battery unit 20A (S102). For example, when the magnetic field characteristics are acquired as a planar distribution of a magnetic field as illustrated in FIG. 6, the battery identification device 400 calculates a difference at the same position between the magnetic field characteristics of the battery unit 20T and the magnetic field characteristics of the battery unit 20A. When both are identical (when the battery unit 20T is the battery unit 20A herein), the difference is 0 on the whole area of the first side surface R1. When both are not identical, there is a difference in a certain area.

As in images of planar distributions illustrated in FIG. 8, a uniform image with no shade as a whole is obtained when there is no difference, and a different part is displayed as a shade when there is a difference. FIG. 8 illustrates that there is a difference between the battery unit 20T and the battery unit 20A as a result of comparison. In this case, the battery identification device 400 determines that the battery unit 20T is not the battery unit 20A. Similarly, the battery identification device 400 determines that the battery unit 20T is not the battery unit 20B through comparison between the battery unit 20T and the battery unit 20B (S103). Similarly, the battery identification device 400 determines that the battery unit 20T is not the battery unit 20C through comparison between the battery unit 20T and the battery unit 20C (S104).

Subsequently, the battery identification device 400 compares the battery unit 20T with the battery unit 20D. In this case, since there is no difference, the battery identification device 400 determines that the battery unit 20T is the battery unit 20D (S105).

With the aforementioned battery identification device 400 according to this embodiment, it is possible to identify a battery type of a target battery unit 20 by comparing a measurement result of magnetic field characteristics of the first side surface R1 of the target battery unit 20 with existing information. With this configuration, the battery identification device 400 according to the embodiment can identify the type of battery without attaching an identification component.

### <First modified example>

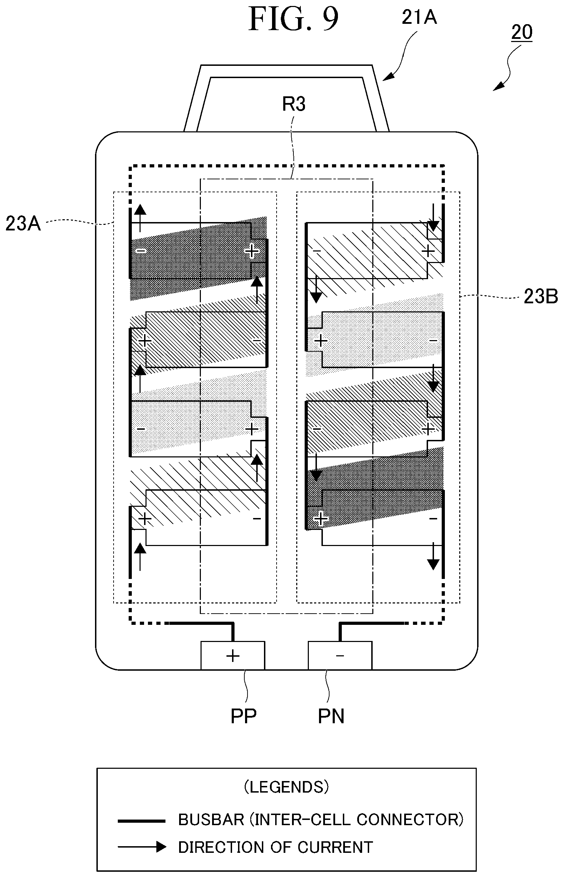

FIG. 9 is a diagram illustrating a modified example of the first side surface R1. The magnetic field characteristics measurer 430 may be configured to perform measurement in a range (for example, a range R3 in the drawing) in which both the magnetic field generated in a battery cell 10 held by the first cell holder 31A and the magnetic field generated in a battery cell 10 held by the second cell holder 31B are observed out of the range of the first side surface R1. By measuring magnetic field characteristics in this range, magnetic field characteristics of more battery cells 10 can be measured at a time, which is highly efficient. With this configuration, since collection of both magnetic field characteristics can be used as the magnetic field characteristics stored as correlation information, it is possible to simplify a configuration and to curb an increase in a load in management.

### <Second modified example>

The battery unit 20 described above in the embodiment is assumed to be mainly used for a vehicle, but the present invention is not limited thereto. The battery identification device 400 may be configured to determine a battery type of a so-called mobile power pack (MPP) which is a detachable portable battery which can be used as a power of a small electric mobile vehicle or a household power source. The MPP is an example of the battery unit 20. A part or whole of the battery identification device 400 may be provided in a battery charging device or a battery returning device (a so-called battery exchanger (BEX)) that can recover and charge a used MPP and re-lend a charged MPP. The battery identification device 400 may be configured as a unified body with the BEX or may be configured as a separate body.

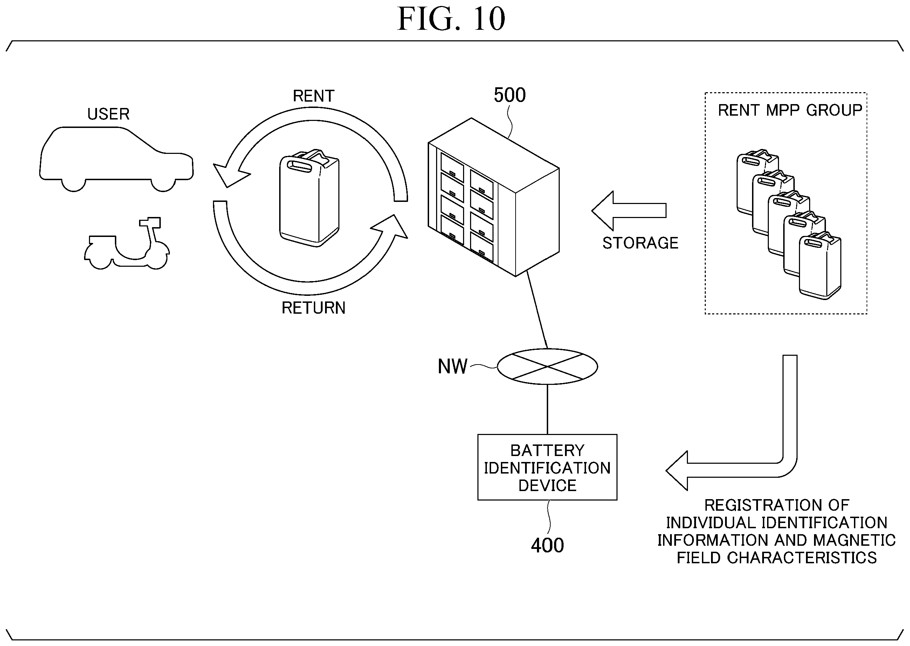

For example, FIG. 10 illustrates an example of a configuration of a battery sharing system 1 including a battery identification device 400 and a BEX 500. The battery sharing system 1 provides a battery sharing service of lending or recovering an MPP to or from a registered user. The battery sharing system 1 has a function of charging an MPP and can charge a recovered MPP and re-lend the charged MPP. For example, a user rents an MPP from the BEX 500 and drives an electric vehicle such as an automobile or a motorbike using the rented MPP. When the state of charge of the MPP in use decreases, the user can return the MPP to the BEX 500 and rent another charged MPP. In the battery identification device 400, information of magnetic field characteristics measured in advance from MPPs used in the battery sharing service is stored as correlation information 442.

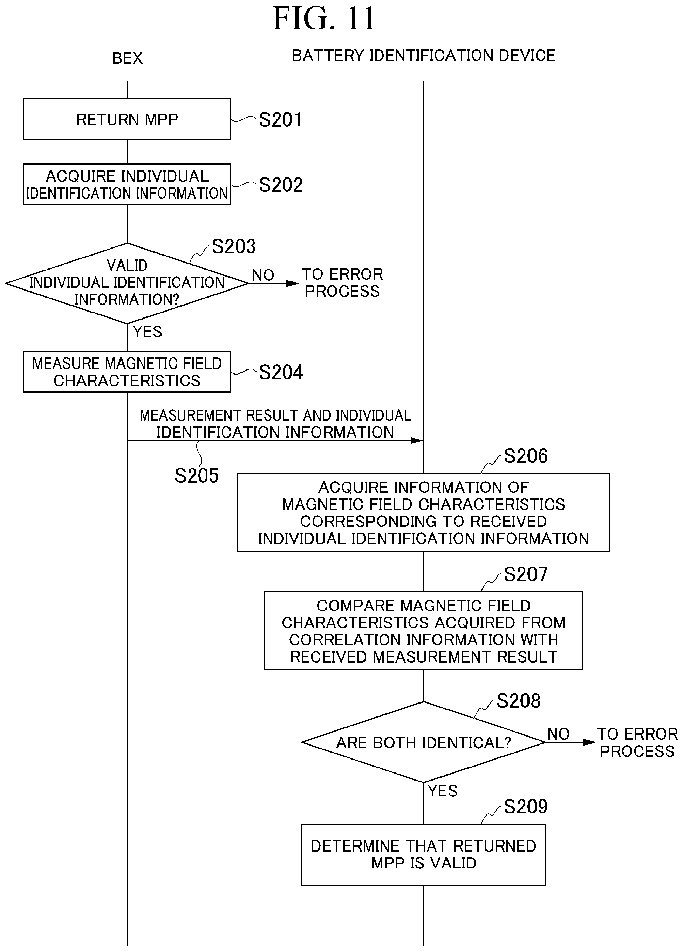

In the battery sharing system 1, the battery identification device 400 and the BEX 500 are communicatively connected to each other and can cooperate as in an example illustrated in FIG. 11 to ascertain validity of an MPP returned to the BEX 500. FIG. 11 is a sequence diagram illustrating an example of a process flow of verifying validity of a returned MPP which is performed by the battery identification device 400 and the BEX 500. First, an MPP is returned to the BEX 500 (S201). Subsequently, the BEX 500 acquires individual identification information from the returned MPP (S202). The BEX 500 determines whether the acquired individual identification information is valid (S203). For example, with reference to management information of the MPP, the BEX 500 determines that the acquired individual identification information is valid when the individual identification information is registered in the management information and determines that the acquired individual identification information is not valid when the individual identification information is not registered. When it is determined that the individual identification information is valid, the BEX 500 measures magnetic field characteristics of the returned MPP (S204) and transmits the measurement result along with the individual identification information to the battery identification device 400 (S205). On the other hand, when it is determined that the individual identification information is not valid, the BEX 500 performs an appropriate error process.

Subsequently, the battery identification device 400 determines a battery type of the returned MPP based on the individual identification information and the measurement result of magnetic field characteristics received from the BEX 500. More specifically, the battery identification device 400 acquires information of magnetic field characteristics corresponding to the received individual identification information from the correlation information 442 (S206), compares the acquired information of magnetic field characteristics with the measurement result of magnetic field characteristics received from the BEX 500 (S207), and determines whether both are identical (S208). The battery identification device 400 determines that the returned MPP is valid when both are identical (S209), and determines that the returned MPP is not valid and appropriately performs an error process when both are not identical. As described above, in the battery sharing system 1, individual identification information of the MPP is acquired by the BEX 500. Accordingly, In this case, the battery identification device 400 may not include the information acquirer 434.

### <Other modified examples>

In the aforementioned embodiment, a cylindrical battery cell 10 is described as a battery cell included in the battery unit 20, but the battery identification method according to the embodiment is based on rotational symmetry of the battery cell 10 and randomness in position of an internal structure (for example, a negative-electrode tab) of the battery cell 10. Accordingly, the battery identification method according to the embodiment can also be applied to identification of a battery unit including battery cells having the same characteristics (rotational symmetry and randomness). For example, the battery identification method according to the embodiment can also be applied to a battery unit including square tubular battery cells (four-times rotational symmetry) or a battery unit including regular-triangle tubular battery cells (three-times rotational symmetry). The randomness in position of the internal structure may be realized due to rotational asymmetry of the internal structure such as a negative-electrode tab. The randomness in position of the internal structure may be realized due to lower rotational symmetry of the internal structure than rotational symmetry of a structure outside of the internal structure (a cylinder in the embodiment).

A mode in which the battery identification device 400 applies an identification current to a battery unit 20 may be based on charging or based on discharging. The output controller 451 may control charging of the battery unit 20 or/and discharging of the battery unit 20.

In the aforementioned embodiment, identification of a battery type may be identifying whether an internal component of the battery unit 20 is a valid product. Since the magnetic field characteristics observed at the time of application of an identification current can also vary when an abnormality occurs in the battery unit 20, the battery identification device 400 may be configured as an abnormality detection device for the battery unit 20 by storing a correlation of the variation in magnetic field characteristics with a type of an abnormality as correlation information 442.

With the battery identification device 400 according to the aforementioned embodiment, it is also possible to identify a battery type of a battery (or a battery cell) in which an IC chip or the like that can output an identification signal is not mounted. Accordingly, it is not necessary to mount an IC chip in a battery, and thus it is possible to solve a problem of a battery due to an interface or the durability of the IC chip.

In the aforementioned embodiment, the battery identification device 400 identifies a battery type based on magnetic field characteristics which are observed when an identification current is applied to a battery cell 10. With measurement of magnetic field characteristics based on application of an identification current, there is a merit that identification accuracy can be secured by applying a current for generating a magnetic field which is not embedded in noise of the terrestrial magnetism or the ambient magnetic field. On the other hand, when a current value applied to a battery cell 10 is monitored, a feature quantity not depending on the current value can be obtained by dividing an intensity of the observed magnetic field by the current value. The battery identification device 400 may be configured to store a correlation of the feature quantity with a battery type as correlation information. In this case, the battery identification device 400 can identify a battery type by comparing the feature quantity observed with application of an arbitrary current to a target battery cell 10 with the correlation information. In this way, whether the battery identification device 400 is to apply an identification current to a battery cell 10 or to apply an arbitrary current thereto may be appropriately selected according to nature or characteristics of an identification target, identification purpose or usage, or the like.

Since a battery configuration is symmetric in the concepts of a positive electrode and a negative electrode, the battery cell 10, the battery unit 20, and the battery identification device 400 may have opposite configurations in view of conceptual symmetry of a positive electrode and a negative electrode.

In the aforementioned embodiment, magnetic field characteristics of a battery cell 10 are measured by scanning the first side surface R1 with a probe P2, but the magnetic field characteristics of a battery cell 10 may be measured together using a sensor array.

## Claims

1. A battery identification device for identifying a battery including a plurality of battery cells, the battery identification device comprising:
a first probe for applying current to the battery,
a second probe for measuring a magnetic field generated around the battery,
a storage device configured to store a program; and
a hardware processor,
wherein the hardware processor executes the program stored in the storage device to perform:
applying, by the first probe, an identification current to the battery, which is a specific current for identifying the battery,
measuring, by the second probe, a distribution of the magnetic field which is generated by applying the identification current to the battery; and
reading information on identity between both results which is determined by comparing a measurement result of the distribution of the magnetic field with a prescribed value of magnetic field information correlated with a type of battery.

2. The battery identification device according to claim 1, wherein
each battery cell of the plurality of battery cells has an outer shape having rotational symmetry with respect to one axis and includes a positive electrode having substantially rotational symmetry with respect to the axis and the negative-electrode having lower rotational symmetry to the axis than that of the outer shape or does not have rotational symmetry to the axis,
the plurality of battery cells are arranged in a fixed position and orientation in the battery such that the axes are parallel to each other, and
the battery identification device is configured to scan the magnetic field along a surface of the battery parallel or perpendicular to the axis.

3. The battery identification device according to claim 1, wherein the battery has a configuration in which a battery module including a plurality of battery cells is accommodated in a battery pack storing individual identification information, and
wherein the hardware processor stores the individual identification information as a type of the battery and stores the prescribed value of the magnetic field information in correlation with the individual identification information.

4. The battery identification device according to claim 3, wherein the hardware processor additionally acquires the individual identification information from the battery pack and identifies individual batteries by acquiring the prescribed value correlated with the individual identification information and comparing the acquired prescribed value with the magnetic field information.

5. The battery identification device according to claim 1, wherein the hardware processor additionally performs a control process of outputting electric power to the battery or the battery cell or receiving an input of electric power from the battery or the battery cell.

6. The battery identification device according to claim 1, wherein the battery has a configuration in which a plurality of battery modules each including a plurality of battery cells are accommodated in a battery pack, and
wherein the hardware processor performs measuring magnetic field characteristics in a range in which the magnetic field characteristics of the plurality of battery modules are observed.

7. The battery identification device according to claim 1, wherein the hardware processor measures the magnetic field using a magnetic element array board in which a plurality of magnetic elements are arranged.

8. A battery identification method of identifying a battery including a plurality of battery cells that is performed by a battery identification device, the battery identification method comprising:
applying, by a first probe, an identification current to the battery, which is a specific current for identifying the battery,
measuring, by a second probe, a distribution of the magnetic field which is generated by applying the identification current to the battery; and
reading information on identity between both results which is determined by comparing a measurement result of the distribution of the magnetic field with a prescribed value of magnetic field information correlated with a type of battery.

9. A non-transitory storage medium storing a program, the program causing an identification device for identifying a battery including a plurality of battery cells to perform:
applying, by a first probe, an identification current to the battery, which is a specific current for identifying the battery,
measuring, by a second probe, a distribution of the magnetic field which is generated by applying the identification current to the battery; and
reading information on identity between both results which is determined by comparing a measurement result of the distribution of the magnetic field with a prescribed value of magnetic field information correlated with a type of battery.

## Patentansprüche

1. Eine Batterie-Identifizierungsvorrichtung zum Identifizieren einer eine Mehrzahl an Batteriezellen aufweisenden Batterie, wobei die Batterie-Identifizierungsvorrichtung aufweist:
eine erste Sonde zum Anlegen von Strom an die Batterie,
eine zweite Sonde zum Messen eines um die Batterie herum erzeugten Magnetfelds,
eine Speichervorrichtung, die zum Speichern eines Programms ausgebildet ist; und
einen Hardwareprozessor,
wobei der Hardwareprozessor das in der Speichervorrichtung gespeicherte Programm ausführt, um Folgendes durchzuführen:
Anlegen, durch die erste Sonde, eines Identifikationsstroms an die Batterie, wobei es sich um einen spezifischen Strom zum Identifizieren der Batterie handelt;
Messen, durch die zweite Sonde, einer Verteilung des Magnetfelds, das durch Anlegen des Identifikationsstroms an die Batterie erzeugt wird; und
Lesen von Identitätsinformation beider Ergebnisse, die durch Vergleichen eines Messergebnisses der Verteilung des Magnetfelds mit einem vorgegebenen Wert von mit einem Batterietyp korrelierender Magnetfeldinformation bestimmt wird.

2. Die Batterie-Identifizierungsvorrichtung nach Anspruch 1, wobei
jede Batteriezelle der Mehrzahl an Batteriezellen, in Bezug auf eine Achse, eine Außenform mit Rotationssymmetrie aufweist, sowie eine positive Elektrode mit im Wesentlichen Rotationssymmetrie in Bezug auf die Achse und eine negative Elektrode mit geringerer Rotationssymmetrie in Bezug auf die Achse als die Außenform oder ohne Rotationssymmetrie in Bezug auf die Achse,
die Mehrzahl an Batteriezellen in der Batterie in einer festen Position und Ausrichtung angeordnet sind, sodass die Achsen parallel zueinander verlaufen, und
die Batterie-Identifizierungsvorrichtung so ausgebildet ist, dass sie das Magnetfeld entlang einer Oberfläche der Batterie parallel oder senkrecht zur Achse scannt.

3. Die Batterie-Identifizierungsvorrichtung nach Anspruch 1, wobei die Batterie eine Konfiguration aufweist, bei der ein Batteriemodul mit einer Mehrzahl an Batteriezellen in einem individuelle Identifizierungsinformation speichernden Batteriepack aufgenommen ist, und
wobei der Hardwareprozessor die individuelle Identifizierungsinformation als Batterie-Typ speichert und den vorgeschriebenen Wert der Magnetfeldinformation in Korrelation mit der individuellen Identifizierungsinformation speichert.

4. Die Batterie-Identifizierungsvorrichtung nach Anspruch 3, wobei der Hardwareprozessor zusätzlich die individuelle Identifizierungsinformation aus dem Batteriepack erfasst und einzelne Batterien identifiziert, indem er den mit der individuellen Identifizierungsinformation korrelierten vorgeschriebenen Wert erfasst und den erfassten vorgeschriebenen Wert mit der Magnetfeldinformation vergleicht.

5. Die Batterie-Identifizierungsvorrichtung nach Anspruch 1, wobei der Hardwareprozessor zusätzlich einen Steuerungsprozess durchführt, zum Ausgeben von elektrischer Energie an die Batterie oder die Batteriezelle oder zum Empfangen einer elektrischen Energiezufuhr von der Batterie oder der Batteriezelle.

6. Die Batterie-Identifizierungsvorrichtung nach Anspruch 1, wobei die Batterie eine Konfiguration aufweist, bei der mehrere jeweils mehrere Batteriezellen aufweisende Batteriemodule in einem Batteriepack aufgenommen sind, und
wobei der Hardwareprozessor Messungen der Magnetfeldeigenschaften in einem Bereich durchführt, in dem die Magnetfeldeigenschaften der Mehrzahl an Batteriemodulen überwacht werden.

7. Die Batterie-Identifizierungsvorrichtung nach Anspruch 1, wobei der Hardwareprozessor das Magnetfeld unter Verwendung einer Magnetelement-Array-Platine misst, auf der eine Mehrzahl an Magnetelementen angeordnet sind.

8. Ein Verfahren zur Identifizierung einer eine Mehrzahl an Batteriezellen aufweisenden Batterie, welches von einer Batterie-Identifizierungsvorrichtung durchgeführt wird, wobei das Verfahren zur Identifizierung einer Batterie umfasst:
Anlegen, durch eine erste Sonde, eines Identifizierungsstroms an die Batterie, wobei es sich um einen spezifischen Strom zum Identifizieren der Batterie handelt;
Messen, durch eine zweite Sonde, einer Verteilung des durch Anlegen des Identifizierungsstroms an die Batterie erzeugten Magnetfelds; und
Auslesen von Information zur Identität zwischen beiden Ergebnissen, die durch Vergleichen eines Messergebnisses der Verteilung des Magnetfelds mit einem vorgeschriebenen Wert von mit einem Batterietyp korrelierender Magnetfeldinformation bestimmt wird.

9. Ein nichtflüchtiges Speichermedium, das ein Programm speichert, wobei das Programm eine Identifizierungsvorrichtung zum Identifizieren einer Batterie mit einer Mehrzahl an Batteriezellen dazu veranlasst, Folgendes auszuführen:
Anlegen, durch eine erste Sonde, eines Identifizierungsstroms an die Batterie, wobei es sich um einen spezifischen Strom zum Identifizieren der Batterie handelt;
Messen, durch eine zweite Sonde, einer Verteilung des durch Anlegen des Identifizierungsstroms an die Batterie erzeugten Magnetfelds; und
Auslesen von Information zur Identität zwischen beiden Ergebnissen, die durch Vergleichen eines Messergebnisses der Verteilung des Magnetfelds mit einem vorgegebenen Wert von mit einem Batterietyp korrelierender Magnetfeldinformation bestimmt wird.

## Revendications

1. Dispositif d'identification de batterie destiné à identifier une batterie incluant une pluralité de cellules de batterie, le dispositif d'identification de batterie comportant :
une première sonde pour appliquer un courant à la batterie,
une deuxième sonde pour mesurer un champ magnétique généré autour de la batterie,
un dispositif de stockage configuré pour stocker un programme ; et
un processeur matériel,
dans lequel le processeur matériel exécute le programme stocké dans le dispositif de stockage pour réaliser :
l'application, au moyen de la première sonde, d'un courant d'identification à la batterie, qui est un courant spécifique destiné à identifier la batterie,
la mesure, au moyen de la deuxième sonde, d'une distribution du champ magnétique qui est généré par application du courant d'identification à la batterie ; et
la lecture d'informations sur l'identité entre les deux résultats qui est déterminée par comparaison d'un résultat de mesure de la distribution du champ magnétique à une valeur prescrite d'informations de champ magnétique corrélée à un type de batterie.

2. Dispositif d'identification de batterie selon la revendication 1, dans lequel
chaque cellule de batterie de la pluralité de cellules de batterie présente une forme externe ayant une symétrie rotationnelle par rapport à un axe et inclut une électrode positive présentant une symétrie sensiblement rotationnelle par rapport à l'axe et l'électrode négative ayant une symétrie rotationnelle par rapport à l'axe inférieure à celle de la forme externe ou n'ayant aucune symétrie rotationnelle par rapport à l'axe,
la pluralité de cellules de batterie sont agencées dans une position et une orientation fixes dans la batterie de sorte que les axes soient parallèles entre eux, et
le dispositif d'identification de batterie est configuré pour balayer le champ magnétique le long d'une surface de la batterie parallèle ou perpendiculaire à l'axe.

3. Dispositif d'identification de batterie selon la revendication 1, dans lequel la batterie présente une configuration dans laquelle un module de batterie incluant une pluralité de cellules de batterie est logé dans un bloc-batterie stockant des informations d'identification individuelles, et
dans lequel le processeur matériel stocke les informations d'identification individuelles en tant que type de la batterie et stocke la valeur prescrite des informations de champ magnétique en corrélation avec les informations d'identification individuelles.

4. Dispositif d'identification de batterie selon la revendication 3, dans lequel le processeur matériel acquiert en outre les informations d'identification individuelles à partir du bloc-batterie et identifie les batteries individuelles en acquérant la valeur prescrite corrélée aux informations d'identification individuelles et en comparant la valeur prescrite acquise aux informations de champ magnétique.

5. Dispositif d'identification de batterie selon la revendication 1, dans lequel le processeur matériel réalise en outre un processus de commande consistant à transmettre une énergie électrique à la batterie ou à la cellule de batterie ou à recevoir une entrée d'énergie électrique provenant de la batterie ou de la cellule de batterie.

6. Dispositif d'identification de batterie selon la revendication 1, dans lequel la batterie présente une configuration dans laquelle une pluralité de modules de batterie incluant chacun une pluralité de cellules de batterie sont logés dans un bloc-batterie, et
dans lequel le processeur matériel réalise une mesure de caractéristiques de champ magnétique dans une plage dans laquelle les caractéristiques de champ magnétique de la pluralité de modules de batterie sont observées.

7. Dispositif d'identification de batterie selon la revendication 1, dans lequel le processeur matériel mesure le champ magnétique à l'aide d'une carte réseau d'éléments magnétiques dans laquelle une pluralité d'éléments magnétiques sont agencés.

8. Procédé d'identification de batterie incluant une pluralité de cellules de batterie qui est réalisé par un dispositif d'identification de batterie, le procédé d'identification de batterie comportant :
l'application, au moyen d'une première sonde, d'un courant d'identification à la batterie, qui est un courant spécifique destiné à identifier la batterie,
la mesure, au moyen d'une deuxième sonde, d'une distribution du champ magnétique qui est généré par application du courant d'identification à la batterie ; et
la lecture d'informations sur l'identité entre les deux résultats qui est déterminée par comparaison d'un résultat de mesure de la distribution du champ magnétique à une valeur prescrite d'informations de champ magnétique corrélée à un type de batterie.

9. Support de stockage non transitoire stockant un programme, le programme amenant un dispositif d'identification destiné à identifier une batterie incluant une pluralité de cellules de batterie à réaliser :
l'application, au moyen d'une première sonde, d'un courant d'identification à la batterie, qui est un courant spécifique destiné à identifier la batterie,
la mesure, au moyen d'une deuxième sonde, d'une distribution du champ magnétique qui est généré par application du courant d'identification à la batterie ; et
la lecture d'informations sur l'identité entre les deux résultats qui est déterminée par comparaison d'un résultat de mesure de la distribution du champ magnétique à une valeur prescrite d'informations de champ magnétique corrélée à un type de batterie.
